Europäisches Patentamt

European Patent Office

Office européen des brevets

(11) Publication number: 0 297 802
A2

# EUROPEAN PATENT APPLICATION

(21) Application number: 88305818.2

(22) Date of filing: 27.06.88

(51) Int. Cl.⁴: **H01L 23/02** , **H01L 31/10** , **G02B 6/42**

(30) Priority: **29.06.87 US 67778**

(43) Date of publication of application:
**04.01.89 Bulletin 89/01**

(84) Designated Contracting States:
**DE FR GB**

(71) Applicant: **POWEREX, INC.**
**Hillis Street**
**Youngwood Pennsylvania 15697(US)**

(72) Inventor: **Leslie, Scott G.**
**11508 Clematis Boulevard**
**Pittsburgh Pennsylvania 15235(US)**
Inventor: **Baum, Edward A.**
**518 Brunswick Drive**
**Greburg Pennsylvania 15601(US)**
Inventor: **Miller, Donald L.**
**17 Pheasant Run Drive**
**Export Pennsylvania 15632(US)**
Inventor: **Jerson, Donald J.**
**R.D. No.1**
**Mt. Pleasant Pennsylvania 15666(US)**

(74) Representative: **Muir, Ian R. et al**
**HASELTINE LAKE & CO. Hazlitt House 28**
**Southampton Buildings Chancery Lane**
**London WC2A 1AT(GB)**

(54) Isolated light-triggered thyristor module.

(57) A light-triggered thyristor module incorporates light-triggered thyristors and associated fiber optics for transmitting light from a remotely located light source. The isolated light-triggered thyristor module includes a housing having an anode contact, a cathode contact and an electrically grounded base plate. In the housing is disposed a thyristor in a semiconductor body. The semiconductor body has a first major surface and an opposing second major surface. The thyristor has an optical gate, cathode emitter and base regions disposed adjacent the first major surface and anode emitter and base regions disposed adjacent the second major surface. A cathode conductive layer and an anode conductive layer contact the first and second major surfaces, respectively, of the semiconductor body, and are electrically connected to the cathode and anode contacts, respectively, of the housing. Disposed in and penetrating the housing is also means for receiving an optical fiber. Additionally, a fiber optic locator member for holding and supporting an optical fiber is disposed adjacent the optical gate of the thyristor. The locator member is of an electrically non-conductive and optically neutral material such that light passing through a fiber within the locator member is substantially unaffected by the locator member. Extending from the fiber receiving means through the fiber optic locator member is an optical fiber. The fiber is positioned within the locator member in such a way that it is in optical communication with the optical gate of the thyristor. Lastly, an anode member electrically and thermally adjoins both the anode conductive layer and the base plate of the housing. The anode member is electrically insulating to allow for high voltage isolation of the module and thermally conducting to allow for heat dissipation.

FIG.1

## ISOLATED LIGHT-TRIGGERED THYRISTOR MODULE

### FIELD OF THE INVENTION

The present invention relates to thyristor modules. More specifically, the present invention relates to electrically isolated light-triggered thyristor modules.

### BACKGROUND OF THE INVENTION

High power isolated modules incorporating thyristors have been known for some years. Electrical isolation of such electrically triggered devices within the package has eliminated the requirements for mechanical clamping and external electrical isolation of the thyristor device.

However, these thyristor modules have had limited application. Under certain circumstances, the thyristor module is desired to be remote or isolated from the circuitry which is used to gate the thyristor. This often requires quite long leads that are affected by electromagnetic interference, for example, lightning or high power transmissions. Many such applications exist for thyristors which require isolation between the thyristor and gating circuits. Often costly precautions must be taken, such as by placing an isolation transformer between the gating circuitry and the thyristor.

Light-triggered thyristors have been used to overcome the deleterious effects caused by electromagnetic interference and provide high voltage isolation between the thyristor and gating circuits. However, light-triggered thyristor modules have not been made that eliminated the requirements for mechanical clamping and external electrical isolation of the module.

A related problem is switching of high voltage circuits by a series string of thyristors. It is essential that all thyristors in the series string be switched at the same time to avoid damage to the thyristors, and since the gate circuit of each thyristor is at a different potential, this is difficult to do electrically. Light-triggered thyristors provide an acceptable way of resolving this problem; however, the packaging problems for such light-triggered thyristors have really made such gating circuits expensive and infeasible for many applications.

### SUMMARY OF THE INVENTION

The present invention is directed to an isolated light-triggered thyristor module. The isolated light-triggered thyristor module includes a housing having an anode contact, a cathode contact and an electrically grounded base plate. Within the housing is a thyristor disposed in a semiconductor body which provides a switching capability. The thyristor has an optical gate through which the thyristor is light activated. The semiconductor body has a first major surface and an opposing second major surface. The semiconductor body has adjacent the first major surface cathode emitter and base regions of the thyristor, and adjacent the second major surface anode emitter and base regions of the thyristor. A cathode conductive layer and an anode conductive layer adjoin the first and second major surfaces, respectively, of the semiconductor body at the cathode emitter region and anode emitter region of the thyristor, respectively. The cathode conductive layer is electrically connected to the cathode contact of the housing and the anode conductive layer is electrically connected to the anode contact of the housing. Disposed through the housing is also a means for receiving an optical fiber. Additionally, a fiber optic locator member for supporting an optical fiber is disposed adjacent the optical gate of the thyristor. The locator member is of an optically neutral material such that light passing through a fiber supported by the locator member is substantially unaffected by the locator member. Extending from the fiber receiving means and supported by the fiber optic locator member is an optical fiber to make optical communication with the optical gate of the semiconductor body. Lastly, an anode member electrically and thermally adjoins both the anode conductive layer and the base plate of the housing. The anode member electrically insulates the semiconductor body from its surroundings, but thermally conducts heat from the semiconductor body, thus preventing possible damage to the thyristor.

EP 0 297 802 A2

The thyristor disposed in the semiconductor body preferably includes a first cathode emitter region adjacent the first major surface, a second cathode base region adjacent the first major surface and cathode emitter region forming a pn junction with the first cathode emitter region, a third anode emitter region adjacent the second major surface, and a fourth anode base region located adjoining the third anode emitter region and the second cathode base region and forming pn junctions with both the second cathode base and third anode emitter regions. Additionally, the optical fiber receiving means preferably includes either a fiber optic connector or a sleeve for an optical fiber.

In a more preferred embodiment of the isolated light-triggered thyristor module, the housing has a third contact and has first and second thyristors disposed in first and second semiconductor bodies disposed within the housing. The thyristors each have optical gates through which they are light activated. The semiconductor bodies each have a first major surface and an opposing second major surface. Disposed adjacent the first major surface of each semiconductor body are cathode emitter and cathode base regions and disposed adjacent the second major surface of the semiconductor body are anode emitter and anode base regions. First and second cathode conductive layers adjoin the first major surface of the first and second semiconductor bodies, respectively, at the cathode emitter regions, and first and second anode conductive layers, adjoin the second major surface of the first and second semiconductor bodies, respectively, at the anode emitter regions. The cathode conductive layer of the first thyristor is electrically connected to the cathode contact in the housing, and the anode conductive layer of the second thyristor is electrically connected to the anode contact. The anode conductive layer of the first thyristor is electrically connected to the cathode conductive layer of the second thyristor by the third contact.

Disposed through the housing in this embodiment is first and second receiving means for receiving optical fibers. Additionally, first and second fiber optic locator members for supporting optical fibers are disposed adjacent the optical gates of the first and second thyristors, respectively. The locator members are of an optically neutral material such that light passing through a fiber within the locator member is substantially unaffected by the locator member. Extending from each fiber receiving means and supported by the fiber optic locator member is an optical fiber optically communicating with the optical gate of thyristor. Finally, first and second anode members electrically and thermally adjoin the anode conductive layers of the respective semiconductor bodies and the base plate of the housing. The anode members are electrically insulating so the thyristor bodies are electrically isolated from their surroundings, but thermally conduct heat from the thyristor bodies, thus preventing possible damage to the thyristor bodies.

Other details, objects and advantages of the invention will become apparent as the following description of the presently preferred embodiments and presently preferred methods of practicing the invention proceeds.

## BRIEF DESCRIPTION OF THE DRAWINGS

In the accompanying drawings, the preferred embodiments of the invention and preferred methods of practicing the invention are illustrated in which:

Figure 1 is a cross-sectional view of an isolated light-triggered thyristor module of the present invention;

Figure 2 is a cross-sectional view of a fiber optic locator of the light-triggered thyristor module illustrated in Figure 1;

Figure 3 is an equivalent circuit diagram of a light triggered thyristor module circuit of the present invention;

Figure 4 is an equivalent circuit diagram of the light-triggered thyristor module of the present invention;

Figure 5 is an equivalent circuit diagram of the light-triggered thyristor module of the present invention;

Figure 6 is a plan view of a second embodiment of a light-triggered thyristor isolated module of the present invention;

Figure 7 is a cross-sectional view of a second embodiment of a light-triggered thyristor isolated module using fiber optic connectors;

Figure 8 is a cross-sectional view of a second embodiment of a light-triggered thyristor isolated module using fiber optic pigtails;

Figure 9 is a schematic diagram of the second embodiment of a light-triggered thyristor isolated module;

3

Figure 10 is a plot of the minimum light triggering power ($P_{LT}$) required to gate the second embodiment of a light-triggered thyristor module as a function of light pulse length;

Figure 11 is a plot of the turn-on delay time (to), versus anode voltage for the second embodiment of a light-triggered thyristor module.

Figure 12 is a plot of the voltage fall time ($t_F$), versus anode voltage for the second embodiment of a light-triggered thyristor module.


## DESCRIPTION OF THE PREFERRED EMBODIMENT


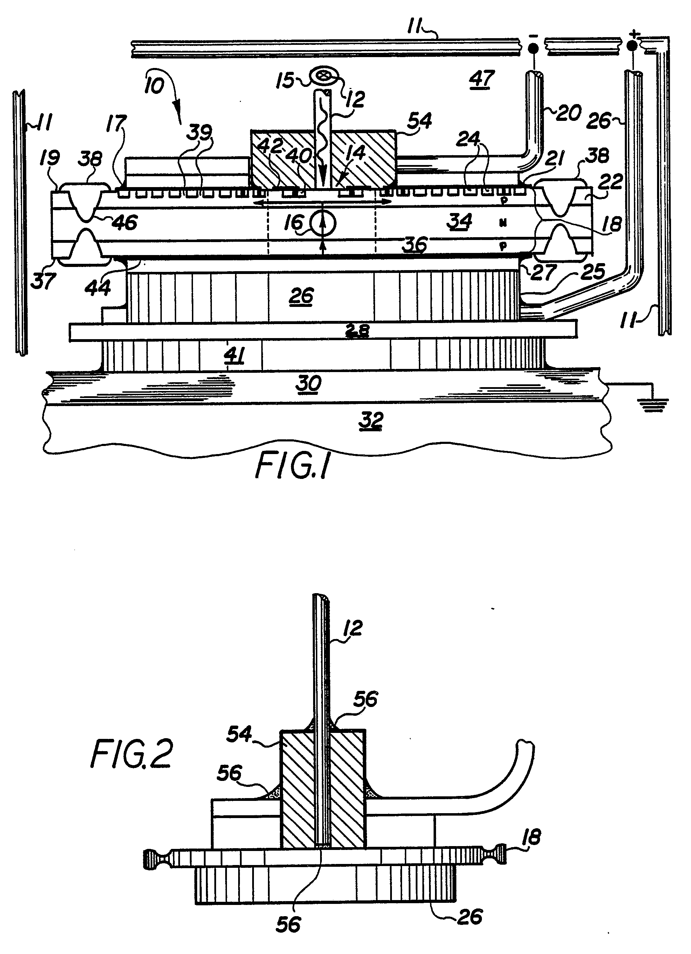

Referring particularly to the drawings, like reference numerals are used to designate identical or corresponding parts throughout the views. More particularly in Figure 1, there is shown an isolated light-triggered thyristor module 10 including a housing 11 and an optical fiber 12. Optical fiber 12 optically communicates with an optical gate 14 of a thyristor in a semiconductor body 18 and is connected to receiving means 15 for receiving an optical fiber 12 which extends through the housing 11. Optical energy is transmitted to the optical gate 14 of the thyristor in the semiconductor body 18, typically of silicon, by optical fiber 12. A cathode conductive layer 21 adjoins the first major surface 19 of semiconductor body 18 at the cathode emitter region 24. Cathode emitter region 24 is formed in semiconductor body 18 adjacent the first major surface 19. The areas 39 of the cathode base region 22 that are located between the cathode emitter regions 24 form shunts 39 adjacent the first major surface 19. Shunts 39 decrease the gating sensitivity of the thyristor disposed in semiconductor body 18 that is to be activated. An anode emitter region 36 and an anode base region 34 are adjacent second major surface 37, and anode conductive layer 44 also adjoins second major surface at anode base region 34.

Preferably a pilot thyristor is also provided in semiconductor body 18 to be activated by optical gate 14 and activate the thyristor in the semiconductor body 18. Specifically, a third metal layer 42, spaced from the cathode conductive layer 21, also contacts the first major surface 19, and at least partially overlaps second cathode emitter region 40 disposed in semiconductor body 18 along first major surface 19. Third metal layer 42 and second cathode emitter region 40, along with the underlying impurity regions, form the pilot thyristor that facilitates the optical gating of the thyristor module 10.

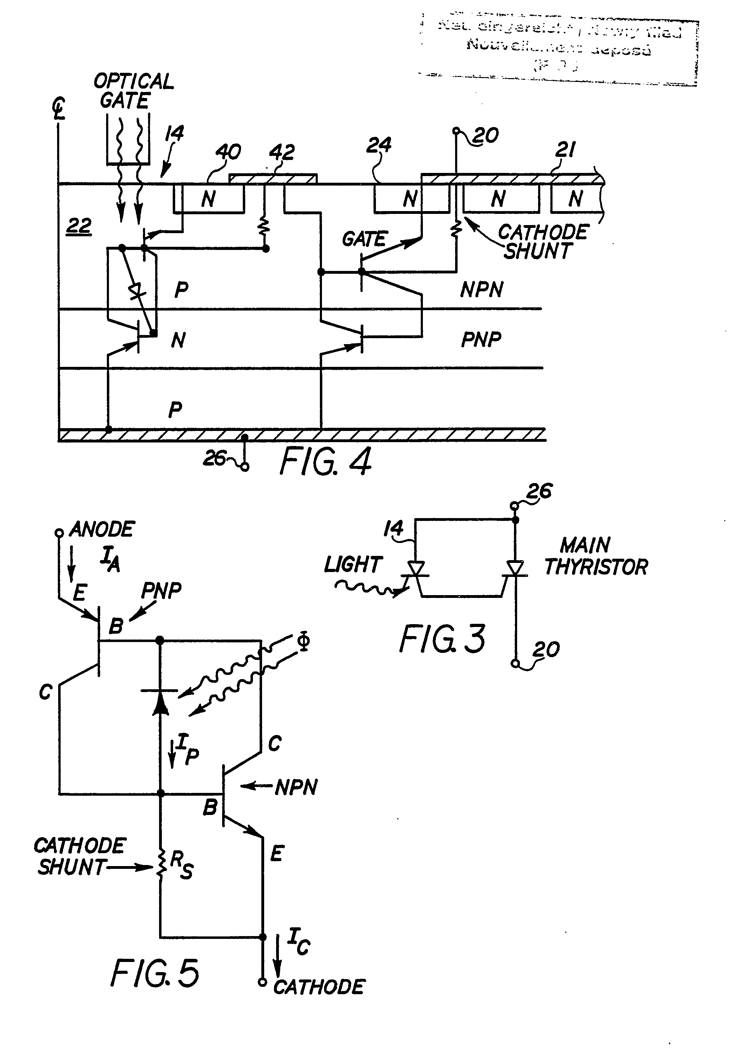

It should be noted that a pilot thyristor does not necessarily have to be used. A pilot thyristor allows relatively less optical energy to be used to activate the main thyristor disposed in the semiconductor body under cathode contact 20. See Figure 3 which shows the schematic diagram of the optical energy which gates on the pilot thyristor which in turn gates on the main thyristor disposed in the semiconductor body.

For a more complete discussion of a pilot thyristor and how it turns on the main thyristor, see V. A. K. Temple and A. P. Ferro, "High power Dual Gate Light-triggered Thyristors", IEEE Trans. Electron Devices, Vol. ED. 23, p. 893, Aug. 1976; and V.A.K. Temple, "Comparison of Light-triggered and Electrically Triggered Thyristor Turn On", IEEE Trans. Electron Devices, Vol. ED. 28, p. 860, July, 1981.

The optical signal that is used to activate the pilot thyristor should be of sufficient intensity and duration to produce an adequate photogenerated current in the silicon semiconductor body 18. The parameters of intensity and duration depend on the concentration of dopants used in the silicon, the thicknesses of the p and n layers, and the dimensions of the cathode emitter regions 24 and 40. It should also be noted that the depth to which the light pulse penetrates depends on the frequency of the light being introduced into the silicon.

The photocurrents generated from the inputted light flow through cathode base region 22 and forward bias the np junction between the cathode emitter region 40 and in turn cathode emitter region 24 and cathode base region 22. The current carriers injected by the cathode emitter regions, in conjunction with the photo generated current, supply the base drive for the cathode base, anode base and anode emitter transistor equivalent. The regenerative effects subsequently drive both transistors equivalent into saturation, switching the thyristor disposed in semiconductor body 18 into the conducting state and allowing current to pass between the cathode conductive layer 21 and anode conductive layer 44. An electrically insulating but thermally conducting anode member 28 is located below anode conductive layer 44. This anode member 28 adjoins base plate 30 which grounds the thyristor module 10. An electrically insulating material 47 fills the housing 11 in order to secure the components therein. A heat sink 32 under base plate 30 dissipates heat from the thyristor module 10.

More specifically, optical gating of a light-triggered thyristor module 10 is accomplished by delivering optical energy emitted by a remotely located light source, i.e., light emitting diode, laser diode, laser, arc lamp, etc., to the optical gate 14 of the thyristor in the semiconductor body 18. A preferred means of

4

transporting light from the source to semiconductor body 18 is through optical fiber 12 that passes through receiving means 15 in housing 11. Receiving means 15 can be either a sleeve or a fiber optic connector which penetrates the housing 11. For maximum communication of light from optical fiber 12 to optical gate 14 of the thyristor in semiconductor body 18, the polished end of fiber 12 is bonded to first major surface 19 of semiconductor body 18 at optical gate 14 with an optically transparent coupling adhesive 56 (epoxy) which has an index of refraction matching that of fiber 12 (see Figure 2). Optical fiber 12 is centered on optical gate 14 and supported by the optical fiber locator 54. Optical fiber locator 54 is fabricated from an optically neutral material such as nylon, micarta or plastic to avoid dispersion of the light passing through the fiber. The optical fiber locator preferably fits in cathode contact 20 and is centered on semiconductor body 18. Typically, cathode contact 20 and anode contact 26 are soldered with solder 17 to the cathode conductive layer 21 and anode conductive layer 44, respectively. Optical fiber locator 54 is preferably held in place by bonding it to the cathode contact 20 with an adhesive.

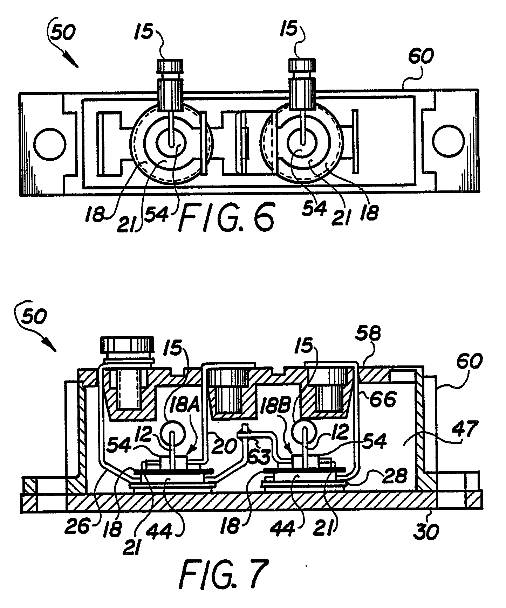

The thyristor is a bistable device, having a high impedance state and a low impedance state. Since no signal is required to maintain either state, the control signal may be of short duration in the form of pulses, and relatively little control energy is required. Accordingly, the use of optically pulsed signals to trigger the thyristor disposed in the semiconductor body 18 is appropriate. Under its broadest definition, the thyristor is any semiconductor switch whose bistable action depends on pnpn feedback. The pnpn thyristor disposed in the semiconductor body 18 that makes up the heart of the thyristor module 10 can be construed to consist of two transistors, an inherent npn and a pnp transistor. See Figures 4 and 5, which show the equivalent circuit of the thyristor. The two transistors are arranged so that the base of one is connected to the collector of the other. (The emitter, base and collector of each transistor in Figure 5 is designated as (E), (B) and (C), respectively). The thyristor is activated by an optical signal providing current flow to the collectors of the pnp and npn transistors. Through the feedback cycle, the transistors drive each other, once initially activated with an optical pulse, into saturation and become latched on. They stay on until the anode or cathode voltages are appropriately changed so semiconductor body 18 is no longer forward biased. See Adolph Blicher, Thyristor Physics, (Springer-Verlag, New York) 1976, for a more discussion of the general operation of a thyristor.

Preferably, a glass or organic passivation 38 is situated around semiconductor body 18 near its perimeter. It is located outside the cathode and anode conductive layers 21 and 44, respectively, and before the edge of semiconductor body 18. The glass passivation 38 is located preferably in a double-sided, deep moat 46 forming a double negative level structure. The purpose of the etch with its angled shape is to increase the surface area so there is a less strong electric field at the surface than in semiconductor body 18. When semiconductor body 18 is reversed-biased the space charge region that forms at the perimeter of semiconductor body 18 causes electric fields which, if strong enough, can cause arc breakdown on the surface of the device. The increased surface area also prevents avalanche breakdown at the surface.

Anode conductive layer 44 is preferably made up of four materials such as aluminum, titanium, nickel and gold. The anode contact layer 26 is preferably made up of two materials such as molybdenum 27 and copper 25. The molybdenum acts as a transition between the silicon and copper which have quite different coefficients of expansion. The molybdenum also prevents the buildup of excessive mechanical stresses in the silicon with changes in temperature. Cathode conductive layer 21 is connected to the cathode contact 20 of the housing 11. Similarly, anode conductive layer 44 is electrically connected to anode contact 26 of the housing 11.

Adjoining anode conductive layer 26 is an anode member 28 that is electrically insulating and thermally conducting. Preferably it is made of beryllium oxide or aluminum oxide. A copper layer 41 is preferably part of anode member 26 adjoining base plate 30 of housing 11. The base plate 30 is connected to ground, and, adjoins on a heat sink 32. Housing 11 is also filled with an electrically insulating material 47 such as epoxy which protects the individual components.

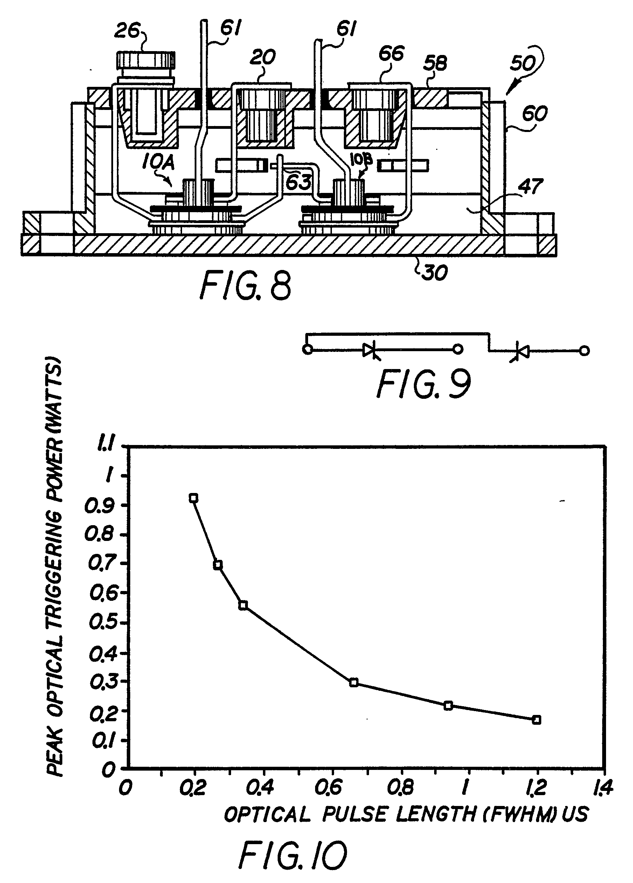

Another embodiment of the isolated light-triggered thyristor module is shown in Figures 6 and 7. The triggering light pulse enters module 50 through fiber receiving means 15 such as fiber optic connector 15 mounted on the side of housing 60. Alternatively, as shown in Figure 8, optical fibers in protective sleeves, known as "pigtails", can be used in place of the connectors 15. In Figure 8, optical fiber 12 enters the module 50 either through an opening in cap 58 or the side of housing 60. The fiber optic pigtail outside of the package is connected optically to a remote gating light source. This connector could be coupled to another optical fiber or directly to the light source. Optical fiber 12 extends from connector 15 to the optical fiber locater 54 situated on semiconductor body 18. Fiber 12 is mounted to semiconductor body 18 through fiber optic locator member 54 as described above for the previous embodiment. When fiber optic connectors 15 are used optical fiber 12 forms a 90° bend in order to be mounted onto semiconductor body 18.

In module 50 there can also be, for example, two thyristors disposed in two semiconductor bodies 18A and 18B, respectively, situated side-by-side. Cathode conductive layer 21 of semiconductor body 18A is connected to the cathode contact 20 of module 50. Semiconductor body 18A has anode conductive layer 44 electrically connected to the cathode conductive layer 21 of second semiconductor body 18B by a third contact 63. The anode conductive layer 44 of second semiconductor body 18B is electrically connected to anode terminal 66 of the housing. Electrically insulating and thermally conducting anode member 28 adjoin the base plate 30 of housing 60 and anode conductive layer 44 adjacent both semiconductor bodies 18A and 18B.

With this structure both semiconductor bodies 18 can be triggered individually or at the same time as long as they are both forward biased. For instance, when an AC signal is applied to the module through anode contact 26 of the housing 60, the value of the signal with respect to the voltages on cathode contact 20 and anode contact 66 of the housing at any given time determines which semiconductor body 18 is capable of triggering. If the signal has a negative value, the first semiconductor body 18A with its anode conductive layer 44 connected to anode contact 26 of housing 60 will stop conducting electricity if current is flowing and cathode contact 20 has a bias voltage more positive than the signal. However, second semiconductor body 18B can trigger when the signal has a negative value and the anode terminal 66 of the housing has a more positive value. The schematic diagram of the module 50 is shown in Figure 9.

An isolated light-triggered thyristor module 50, can be designed according to the above description. It can have a rated blocking voltages of up to 1400 volts and average currents of 90 amperes. The module can be gated, for example, on with an inexpensive Gallium Arsenide (GaAs) laser diode emitting infrared radiation at a wavelength of 904 nanometers. A glass-passivated, 16 mm diameter semiconductor body 18 can be soldered to a metallized beryllium-oxide (BeO) anode member 28, which provides the electrical isolation between the semiconductor body 18 and base plate 30. Anode member 28 is, in turn, soldered to base plate 30. This structure provides a low thermal impedance between the semiconductor element and external heat sink for efficient cooling of semiconductor body 18.

Cathode conductive layer 21 of the semiconductor body 18 provides electrical contact to cathode contact 20 of housing 11 in addition to allowing access to the optical gate 14. In the version with the integral fiber optic connector 15, the connector 15 is mounted on the side of module 50 and the internal fiber optic light guide is bent through a 90° angle to facilitate communication to the optical gate 14 of the thyristor in the semiconductor body 18. The fiber optic light locator 54 is positioned adjacent optical gate 14 of the thyristor in the semiconductor 18 by means of a transparent epoxy with an index of refraction matching that of optical fiber 12. Termination of the pn junctions is accomplished by a double-sided, deep moat 46 forming a double negative bevel structure which is filled with a glass coating 38 for passivation and mechanical support. The entire module is filled with two electrically insulating materials such as a soft gel epoxy 47A and a hard epoxy 47B to immobilize and protect the individual components.

Table 1, lists typical operating characteristics of a module 50.

Table 1

| Operating Characteristics of a Light-Triggered Thyristor Isolated Module | |
|---|---|
| CHARACTERISTIC | VALUE |
| Repetitive Peak Forward Blocking Voltage at $T_J$ = 125$^\circ$C, $V_{DRM}$ | 1400 V |
| Repetitive Peak Reverse Blocking Voltage at $T_J$ = 125$^\circ$C, $V_{RRM}$ | 1400 V |
| Forward and Reverse Peak Leakage Current at $T_J$ = 125$^\circ$C, $I_{DRM}$, $I_{RRM}$ | 15 mA |
| Average Forward Current at $T_J$ = 125$^\circ$C, $I_T$(av) | 90 A |
| Forward Voltage Drop at $I_{TM}$ = 250 A, $T_J$ = 25$^\circ$C, $V_{TM}$ | 1.55 V |
| Optical Energy to Trigger at $V_D$ = 40 V, tp = 0.2 $\mu$s, $\lambda$ = 904 nm, $E_{LT}$ | 0.1-0.3 $\mu$Joule |
| Peak Optical Power to Trigger at $V_D$ = 40 V, tp = 0.2 l.ms, $\lambda$ = 904 nm, $P_{LT}$ | 0.5-1.5 W |
| Typical Turn-One Time at $V_D$ = 500 V, $P_{LT}$ = 1.5 W, tp = 0.2 $\mu$s, $t_{on}$ | 0.9-1.5 $\mu$s |
| Typical Turn-Off Time at $T_J$ = 125$^\circ$C, $t_q$ | 25-100 $\mu$s |
| Critical dv/dt Immunity to 0.8 $V_{DRM}$ at $T_J$ = 125$^\circ$C, Exponential | 300 V/$\mu$s |
| Minimum dI/dt Capability Non-Repetitive at $T_J$ = 125$^\circ$C | 100 A/$\mu$s |
| V Isolation, $V_{RMS}$ | 2500 V |
| Thermal Resistance: Junction to Base Plate, $R_{\theta JC}$ | 0.4$^\circ$C/Watt |
| Minimum-Maximum Operating and Storage Temperature, $T_J$ | -40 to +125$^\circ$C |

The values listed in Table 1 for the optical triggering energy, $E_{LT}$, and triggering power, $P_{LT}$, required to turn-on the thyristor were obtained by measuring the output of the optical fiber 12 connecting the module 50 to the laser diode source.

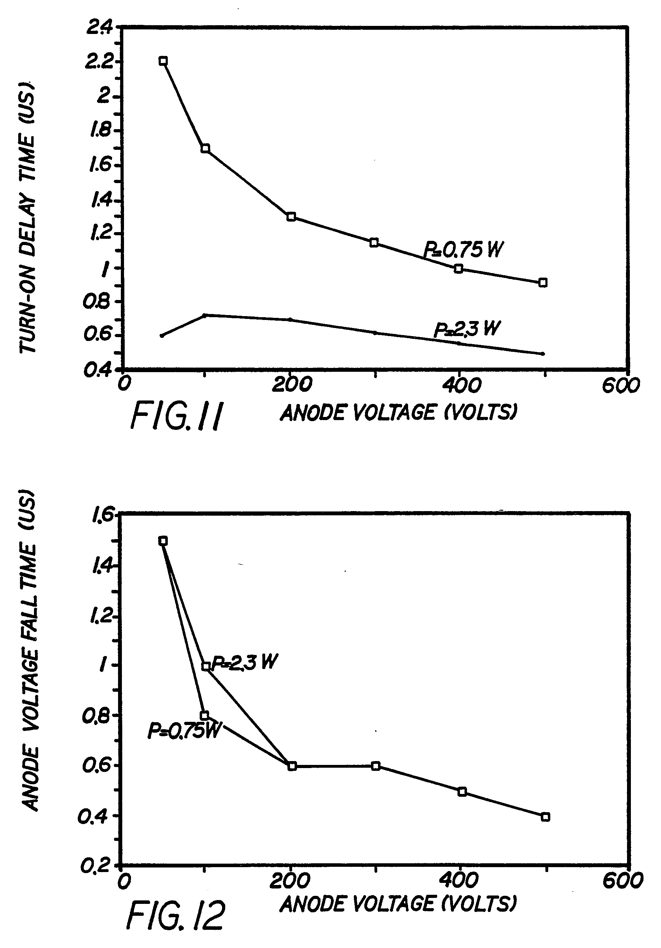

The effects of optical pulse length, pulse power, and anode voltage on the turn-on characteristics can also be determined. The average minimum optical triggering power, $P_{LT}$, required to turn-on the thyristor (at an anode voltage of 40V) is plotted in Figure 10 as a function of the light pulse length for several thyristors. As indicated by the curve, $P_{LT}$ decreases monotonically with increasing light pulse length to approximately 0.150 W. The $E_{LT}$, which is the integral of $P_{LT}$*t, increased by only 20% over this range of pulse lengths.

The turn-on delay time, $t_D$ and voltage fall time, $t_F$ (where $t_{on} = t_D + t_F$), are plotted in Figures 11 and 12 as functions of the anode voltage and optical power for a typical module 50. The turn-on delay was measured from the onset of the optical pulse to 90% of $V_D$ and $t_F$ was measured from 90% $V_D$ to 10% $V_D$. The lower optical power of 0.75 W is the $P_{LT}$ for the thyristor at $V_D$ = 40 V and light pulse length of 0.195 $\mu$s. The higher optical power of 2.3 W is approximately 3*$P_{LT}$. The $t_D$ is seen to decrease with increasing $V_D$ at low optical gate drives. At higher optical gate drives, however, $t_D$ is increased beyond 200 V. For the most part, $t_F$ decreases with increasing $V_D$ and is independent of the optical gate drive, as one would expect.

Although the invention has been described in detail in the foregoing embodiments for the purpose of illustration, it is to be understood that such detail is solely for that purpose and that variations can be made therein by those skilled in the art without departing from the spirit and scope of the invention except as it may be described by the following claims.

## Claims

1. An isolated light-triggered thyristor module comprising
a housing having an anode contact, a cathode contact and an electrically grounded base plate;
a thyristor disposed in a semiconductor body disposed in the housing, said semiconductor body having a first major surface and opposing second major surface, said thyristor having a cathode emitter region and a cathode base region disposed adjacent the first major surface of the semiconductor body, an optical gate adjacent said first major surface and anode emitter region and anode base region disposed adjacent the second opposed major surface of the semiconductor body;
a cathode conductive layer and an anode conductive layer contacting the first and second major surfaces, respectively, of the semiconductor body, and electrically connected to the cathode and anode contacts, respectively, of the housing;
means for receiving an optical fiber disposed in and penetrating said housing;
a fiber optic locator member for holding and supporting an optical fiber, said locator member disposed adjacent the optical gate of the thyristor, said locator member being of an electrically non-conductive and optically neutral material such that light passing through a fiber within the locator member is substantially unaffected by the locator member;

an optical fiber extending from the fiber receiving means through the fiber optic locator member and being in optical communication with the optical gate of the thyristor;

an anode member electrically and thermally adjoining both the anode conductive layer and the base plate of the housing, said anode member being electrically insulating and thermally conducting; and

an electrically insulating material that fills the housing.

2. An isolated light-triggered thyristor module as described in Claim 1 wherein the semiconductor body contains a pilot thyristor for triggering by the optical gate and triggering the thyristor in the semiconductor body.

3. An isolated light-triggered thyristor module as described in Claim 2 wherein the receiving means in the housing is a fiber optic connector.

4. An isolated light-triggered thyristor module as described in Claim 2 wherein the receiving means in the housing is a sleeve for an optical fiber.

5. An isolated light-triggered thyristor module as described in Claim 2 wherein the semiconductor body has a perimeter and there is a passivation layer adjacent the perimeter.

6. An isolated light-triggered thyristor module as described in Claims 3 or 4 wherein the thyristor in the semiconductor body has a first cathode emitter region adjacent the first major surface, a second cathode base region adjacent the first major surface forming a pn junction with the first region, a third anode emitter region adjacent the second major surface, and a fourth anode base region located adjacent the third anode emitter region and adjoining the second cathode base region and forming pn junctions with said regions.

7. An isolated light-triggered thyristor module comprising:

a housing having an electrically grounded base plate, an anode terminal, a cathode contact and an anode contact;

a first thyristor disposed in a first semiconductor body and a second thyristor disposed in a second semiconductor body and both disposed in said housing, said first semiconductor body and said second semiconductor body each having a first major surface and an opposing second major surface, said first thyristor and said second thyristor each having an optical gate, and cathode emitter and base regions disposed adjacent the first major surface and anode emitter and base regions disposed adjacent the second major surface;

a first and a second cathode conductive layer electrically contacting the first major surface of the first and second semiconductor bodies, respectively, and a first and a second anode conductive layer electrically contacting the second major surface of the first and second semiconductor bodies, respectively, said anode conductive layer of the first semiconductor body electrically connected to the anode contact of the housing and also to the cathode conductive layer of the second semiconductor body through the third contact, said cathode conductive layer of the first semiconductor body electrically connected to the cathode contact of the housing and said anode conductive layer of the second semiconductor body electrically connected to the anode contact of the housing;

first means and second means for receiving optical fibers disposed in and penetrating said housing;

first and second fiber optic locator members for holding and supporting optical fibers, said locator member disposed adjacent the optical gate of the first and second thyristors, respectively, said locator members being of an electrically non-conductive and optically neutral material such that light passing through a fiber is substantially unaffected by the locator member;

an optical fiber extending from each fiber receiving means through each fiber optic locator member and being in optical communication with the optical gate of each thyristor;

a first and second anode member electrically and thermally adjoining both the anode conductive layer of the respective semiconductor bodies and the base plate of the housing, said anode member being electrically insulating and thermally conducting; and

an electrically insulating material that fills the housing.

8. An isolated light-triggered thyristor module as described in Claim 7 wherein each semiconductor body contains a pilot thyristor for triggering by the optical gate and triggering one of the thyristors.

9. An isolated light-triggered thyristor module as described in Claim 7 wherein the first and second fiber receiving means in the housing are fiber optic connectors.

10. An isolated light-triggered thyristor module as described in Claim 7 wherein the first and second fiber receiving means in the housing are fiber optic sleeves.

11. An isolated light-triggered thyristor module as described in Claims 2 and 8 wherein the anode member is made out of beryllium oxide or aluminum oxide.

12. An isolated light-triggered thyristor module as described in Claim 8 wherein each semiconductor body has a perimeter and there is a passivation layer adjacent the perimeter thereof.

Neu eingereicht / Newly filed
Nouvellement déposé
(R 35)

FIG.1

FIG.2

Neu eingereicht / Newly filed
Nouvellement deposé
(FR)

FIG. 4

OPTICAL GATE

14

40 42 24 20 21

N N N N N

22 P

N

NPN

PNP

P

GATE CATHODE SHUNT

26 FIG. 4

FIG. 3

14 LIGHT 26 MAIN THYRISTOR 20

FIG. 5

ANODE $I_A$

E PNP B

C

$I_P$ Φ

C NPN

B

CATHODE SHUNT $R_S$ E

$I_C$ CATHODE

FIG. 6

FIG. 7

FIG. 8

FIG. 9

PEAK OPTICAL TRIGGERING POWER (WATTS)

OPTICAL PULSE LENGTH (FWHM) US

FIG. 10

FIG. II

FIG. 12